# EUROPÄISCHE PATENTSCHRIFT

(11) **EP 0 194 481 B1**
(45) Veröffentlichungstag und Bekanntmachung des Hinweises auf die Patenterteilung: **13.10.1993**
(21) Anmeldenummer: 86102203.6
(22) Anmeldetag: 20.02.1986
(51) Int. Cl.: H05K 13/00, H01L 21/00

(54) **Behälter zur Aufbewahrung und Beförderung von Siliciumscheiben**
Container for the storage and the transport of silicium discs
Récipient pour le stockage et le transport de disques de silicium

(30) Priorität: 08.03.1985 IT 4778885
(43) Veröffentlichungstag der Anmeldung: 17.09.1986
(73) Patentinhaber: MEMC ELECTRONIC MATERIALS S.p.A., I-28100 Novara (IT)
(72) Erfinder: Rissotti, Luigi, Vercelli (IT); Morici, Moreno, Cameri (IT); Leoni, Fabrizio, S-Trecate (IT); Girardi, Adriano, Bellinzago (IT)
(74) Vertreter: Meyer, Joachim, Dipl.-Ing.

(56) Entgegenhaltungen:
- DE-A- 3 330 720
- DE-A- 3 429 243
- DE-A- 3 429 244
- US-A- 4 043 451

## Beschreibung

Die vorliegende Erfindung bezieht sich auf Verpackungsbehälter, insbesondere zur Aufbewahrung und Beförderung von Siliciumscheiben, die aus einem zum Spritzpressen geeigneten thermoplastischen Werkstoff hergestellt werden.

Es sind schon verschiedene Arten von Beförderungsbehältern für Siliciumscheiben bekannt, von denen jeder besondere Maßnahmen zum Schützen des Produktes aufweist. Im allgemeinen besteht jeder Beförderungsbehälter aus einer Kassette zur Aufnahme von Siliciumscheiben und einer zweiteiligen Schachtel (Hauptschachtel und Deckel). Hauptschachtel und Dekkel werden beim Schließen miteinander in der Weise fest verbunden, daß die Kassette festgeklemmt und die Siliciumscheiben in vorbestimmter Anordnung festgehalten werden. Auf diese Weise werden Brüche oder Mikrobewegungen der Siliciumscheiben vermieden, wodurch der Kunststoff abgerieben und das Silicium, insbesondere beim Schließen der Schachtel, verunreinigt werden könnten.

Es wurde nun aber unter anderem festgestellt, daß bei diesen bekannten Behältern ein gleichmäßiges und wirksames Waschen der beiden Schachtelteile vor dem Einsetzen des Produktes wegen der großen Tiefe der Scheibensitze nicht einwandfrei durchgeführt werden kann, wobei diese Tiefe auch das Austrocknen der Sitze nachteilig beeinträchtigt. Zusätzlich wurde festgestellt, daß bei den bekannten Anordnungen der Sitz der inneren Kassette und der darin befindlichen Siliciumscheiben nicht ausreichend fest ist, so daß immer noch Bewegungen der Scheiben bei geschlossenen Behältern möglich sind. Es bestand deshalb die Aufgabe, diese Nachteile der bekannten Verpackungsbehälter zu beseitigen.

Ausgehend von dieser Aufgabe schlägt die vorliegende Erfindung eine Lösung derselben vor, die im kennzeichnenden Teil des Anspruchs 1 angegeben ist. Bevorzugte Durchführungsformen sind in den Unteransprüchen angegeben.

Aus dem Dokument DE-A-33 30 720 ist ein Behälter zur Aufbewahrung und Beförderung von Siliciumscheiben bekannt, bestehend aus drei Teilen, und zwar einer unteren Halbschachtel, einer oberen Halbschachtel, welche miteinander zur Bildung der äußeren Schutzschachtel formschlüssig lösbar verbunden werden und in dieser Schachtel angeordneten Kassetten, welche zwischen der unteren und oberen Halbschachtel verteilt sind, sich untereinander ergänzen und miteinander zusammenwirken, um die beiden Halbschachteln zu schließen und miteinander zu blockieren, Mitteln im inneren Bodenteil der unteren und oberen Halbschachtel, welche die Verstellung der Kassetten in jeder Richtung verhindern, und Hilfsmitteln, vorgesehen nur an der oberen Halbschachtel, die der Blockierung der Kassette und zum Festhalten der Siliciumscheiben dienen.

Wesentlich und besonders wichtig ist die Form der Füße der Kassette gemäß der vorliegenden Erfindung.

Die beiden Fußleisten der Kassette sind so angeordnet, daß jedes Ende derselben eine rechtwinklig nach außen ausgebogene Rippe aufweist, die gemeinsam mit den Leisten in ein in dem Boden der Schachtel vorgesehenes Profilstück einrastet. Dieses Profilstück weist eine Länge auf, die dem Abstand zwischen den beiden Leisten der Kassette - das ist zwischen den zwei rechtwinklig ausgebogenen Teilen der Fußleisten - entspricht. Damit wird ein sicheres Einsetzen der Kassette auf dem Bodenteil des Behälters gewährleistet.

Die genannte Querrippe soll nicht unbedingt die ganze Länge des Profilstückes einschließen; es genügt, daß die nach außen gebogene Leiste der Hälfte der Breite des Boden-Profilstückes entspricht.

Der Abstand zwischen den beiden Fußleisten der Kassette soll so ausgewählt werden, daß der Außenrand dieser Leisten auf dem Innenrand des Längs-Profilstückes des Schachtelbodens zum Anliegen kommt. Auch dies stellt ein wichtiges Merkmal der vorliegenden Erfindung dar, welches in den bekannten Behältern für die Siliciumscheiben nicht vorhanden ist.

Bei den jetzt bekannten Lösungen wird die Kassette auf dem Behälterboden durch Verstrebungen befestigt, welche auf den Seitenwänden des Behälters angeordnet sind und unmittelbar an die Außenwand der Kassette angreifen.

Eine weitere, bei der Befestigung der Kassette im Bodenteil bekannte Maßnahme besteht darin, daß in den Fußleisten Einschnitte vorgesehen sind, in welche entsprechende Vorsprünge des Bodenteiles des Behälters einrasten.

Die Befestigung des oberen Teiles der Kassette im Schachteldeckel wird erfindungsgemäß mit Hilfe von Halterippen durchgeführt. Solche Rippen sind an und für sich aus Figur 1 der DE- A-33 30 720 bekannt. Aus dieser Schrift kann man entnehmen, daß diese Leisten sich nur senkrecht aus dem Behälterdeckel ins Innere des Behälters soweit erstrecken, bis sie mit den Rändern der Siliciumscheiben seitlich in Berührung kommen. Ein wesentliches Merkmal der Rippen gemäß der vorliegenden Erfindung ist darin zu sehen, daß sie ausgebogen sind, und zwar so, daß nur das Ende des ausgebogenen Teiles den Rand der Siliciumscheiben berührt. Im Berührungspunkt weisen diese Rippen, ähnlich wie die bekannten Rippen, eine Kerbe auf, welche einen Sitz für den Band der Siliciumscheibe bildet.

Die winklige Ausgestaltung der Rippen weist verschiedene Vorteile auf. Der Hauptvorteil besteht darin, daß beim Schließen des Behälters die Siliciumscheiben die Enden dieser Rippen nach oben drücken, so daß der Berührungspunkt zwischen den Rippen und den Siliciumscheiben fest bleibt und eine Relativbewegung vermieden wird. Bei den Rippen nach dem Stand der Technik dagegen werden beim Schließen des Behälters die Rippen nach außen gedrückt; sie gleiten aber längs den Bändern der Siliciumscheiben und verunreinigen dadurch diese mit dem abreibbaren Kunststoff.

Die Höhe der die Siliciumscheiben enthaltenden Kassette entspricht ganz genau dem Abstand (beim geschlossenen Behälter) zwischen dem Boden des unteren Teiles der Schachtel und den Profilstücken von dessen oberen Teil (Deckel).

Ein weiteres Baumerkmal für eine bessere Befestigung der Siliciumscheiben in der Kassette besteht erfindungsgemäß in einer einwandfreien Abrundung des unteren Kassettenteiles, in dem die Siliciumscheiben angeordnet sind. Bei den Kassetten der bekannten Behälter hat man keine vollständige Abrundung, sondern nur eine Teilabrundung oder eine aus einer Mehrzahl in gebrochenen Geraden bestehende winklige Abrundung.

Die Baumerkmale der beiden Schachtelteile des Behälters haben sich praktisch als sehr vorteilhaft erwiesen. An erster Stelle erlauben sie die Herstellung des Boden- und Deckelteiles in derselben Form, so daß diese beiden Teile untereinander leicht umgetauscht werden können. In der Tat unterscheiden sie sich voneinander nur durch den Anbau der Halterippen am Deckelteil, wobei dieser Anbau mit Hilfe eines beweglichen Wagens in der Preßform durchgeführt wird.

Der untere Rand eines jeden dieser Teile weist an der Umfanghälfte einen Vorsprung auf, dessen Höhe der Höhe eines entsprechenden Absatzes entspricht, welcher sich auf der anderen Umfanghälfte erstreckt. Damit wird erreicht, daß der Vorsprung eines Boden- oder Deckelteiles immer ganz genau mit dem Besatz des anderen Teiles in Eingriff kommt, so daß, wenn der Behälter geschlossen wird, immer ein ununterbrochenes und höhengleiches Zusammenpassen der oberen und unteren Behälterteile gewährleistet wird.

In Querrichtung gesehen ist der Randvorsprung gegenüber dem Randabsatz nach außen versetzt, wodurch - sei es in Querrichtung, sei es in Längsrichtung - eine sehr präzises Zusammenpassen erreicht wird.

Jeder Schachtelteil weist an dessen einer Seite einen nach außen elastisch ausbiegbaren Blockierhaken auf und auf der anderen Seite einen Eingriffzahn für den elastischen Haken des anderen Teiles. Blockierhaken und Eingriffzahn sind demzufolge die Einzelteile eines Schnappverschlusses.

Diese Schließvorrichtung hat folglich eine solche Ausgestaltung, daß jeder Boden- und Deckelteil ein positives Verschlußteil auf einer Seite und ein negatives Verschlußteil auf der anderen Seite hat, welche mit den entsprechenden Verschlußteilen des anderen Teiles in Eingriff kommen und damit den Verschluß bilden.

Weitere Einzelheiten und Vorteile der vorliegenden Erfindung können ganz klar aus der folgenden Beschreibung mit Bezug auf die anliegenden Zeichnungen entnommen werden, in welchen eine bevorzugte Ausführungsform beispielhaft illustriert ist.

In den Zeichnungen zeigen
- Figur 1: eine Aufsicht auf den Behälter gemäß der vorliegenden Erfindung;
- Figur 2: eine ähnliche, aber teilweise ausgebrochene Aufsicht auf den erfindungsgemäßen Behälter;
- Figur 3: eine teilweise ausgebrochene Ansicht der längeren Behälterseite;
- Figur 4: einen Schnitt längs der Linie A-A der Figur 3;
- Figur 5: einen Schnitt des oberen Deckelteiles des Behälters längs der Linie B-B der Figur 2;
- Figur 6: eine Ansicht der kürzeren Seite des Deckelteiles des Behälters;
- Figur 7: einen Schnitt der kürzeren Seite des Deckelteiles des Behälters gemäß Figur 6 längs der Linie C-C der Figur 5;
- Figur 8: eine Ansicht einer Kassette mit nur teilweise gezeichneten Aushöhlungen für die Aufnahme der Siliciumscheiben;
- Figur 9: eine Aufsicht der Kassette zur Aufnahme der Siliciumscheiben;
- Figur 10: einen Schnitt der Kassette gemäß Figur 9 längs der Linie D-D.

Wie man aus den Zeichnungen entnehmen kann, weist der Behälter eine zweiteilige Schachtel und eine Kassette für die Siliciumscheiben auf. Wie schon erwähnt wurde, haben die beiden Schachtelteile, d.h. der Bodenteil und der Deckelteil, den gleichen Aufbau und die gleiche Tiefe (mit Ausnahme der Rippenanordnung) und können somit in einer einzigen Preßform hergestellt werden.

Ein erstes Baumerkmal der beiden Schachtelteile bezieht sich auf die Mittel für den Verschluß derselben. Die Mittel bestehen aus einer besonderen Ausbildung der Umfangsränder und der an den kürzeren Seiten eines jeden Schachtelteiles vorgesehenen Teile eines Schnappverschlusses.

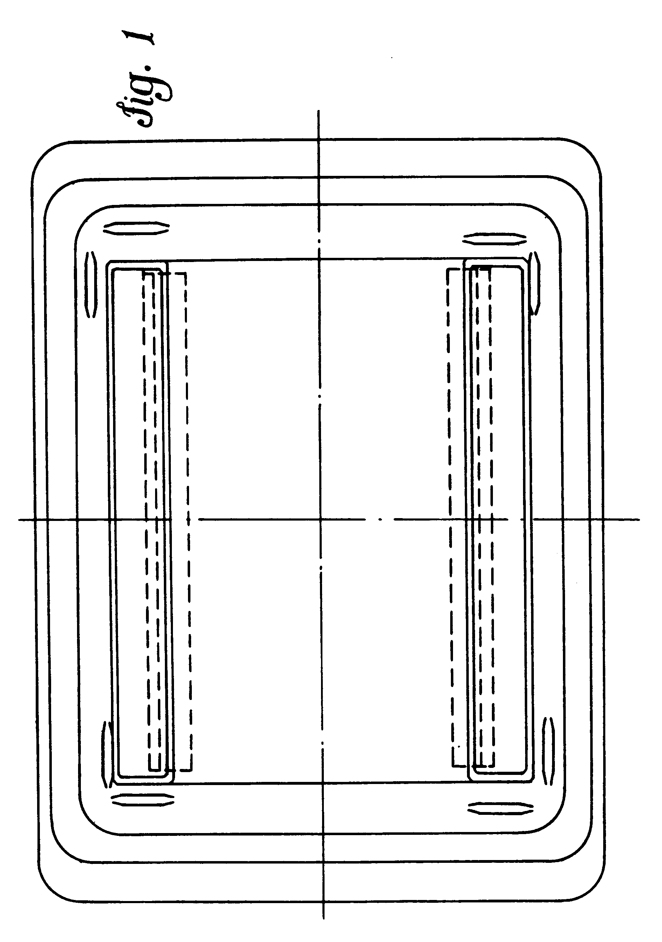

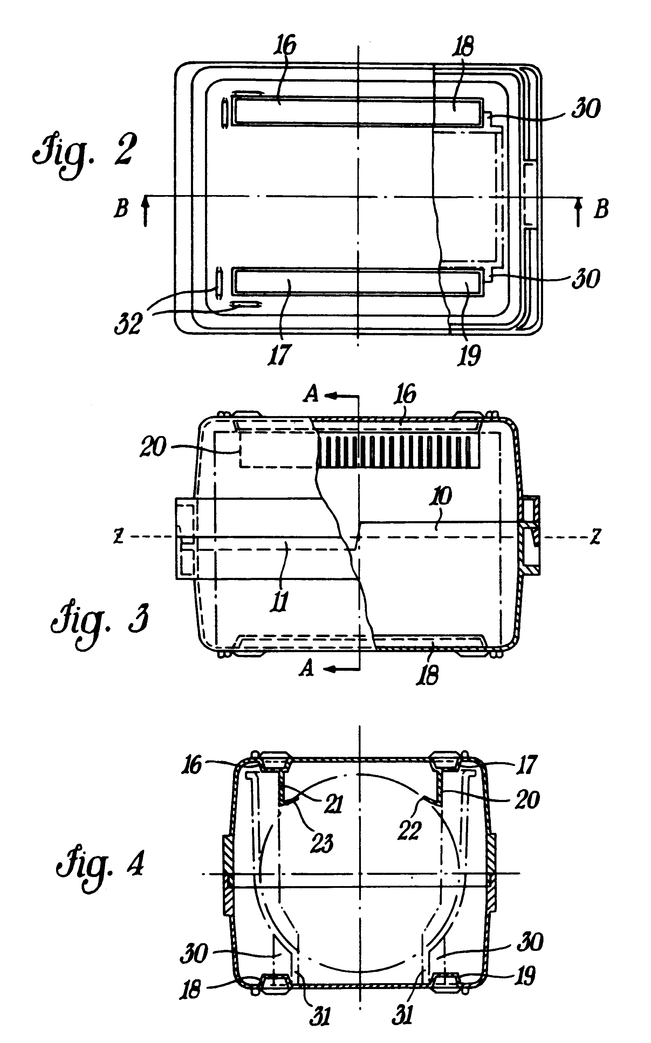

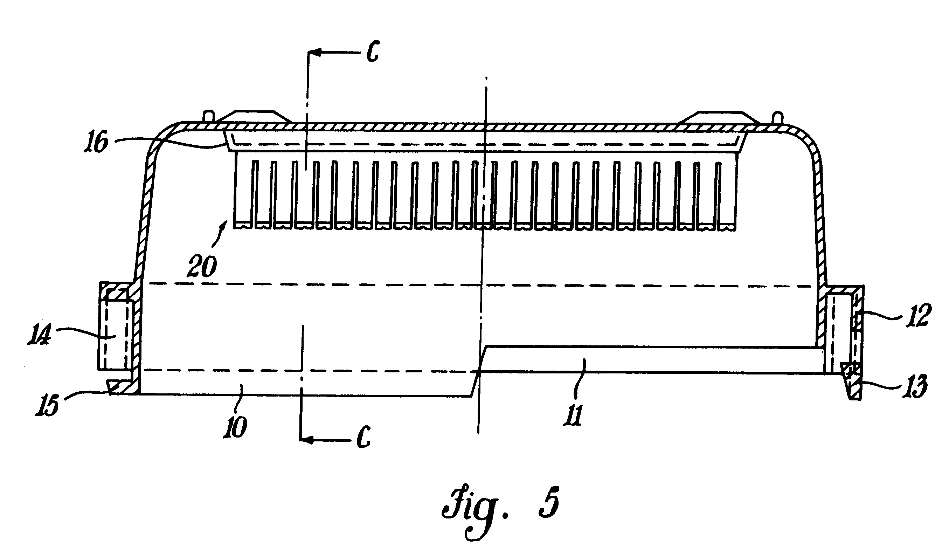

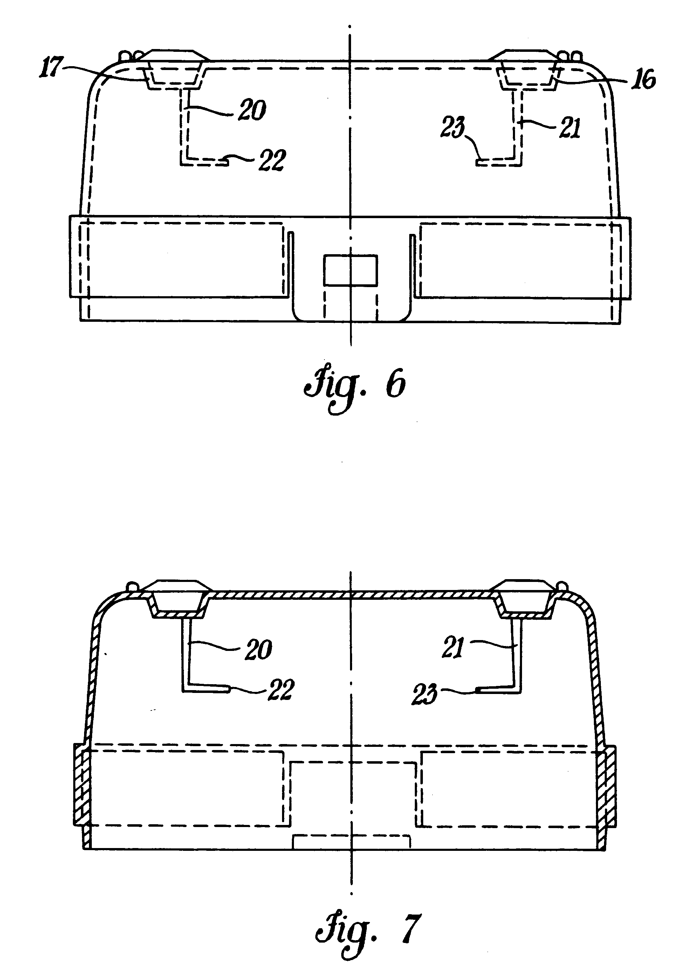

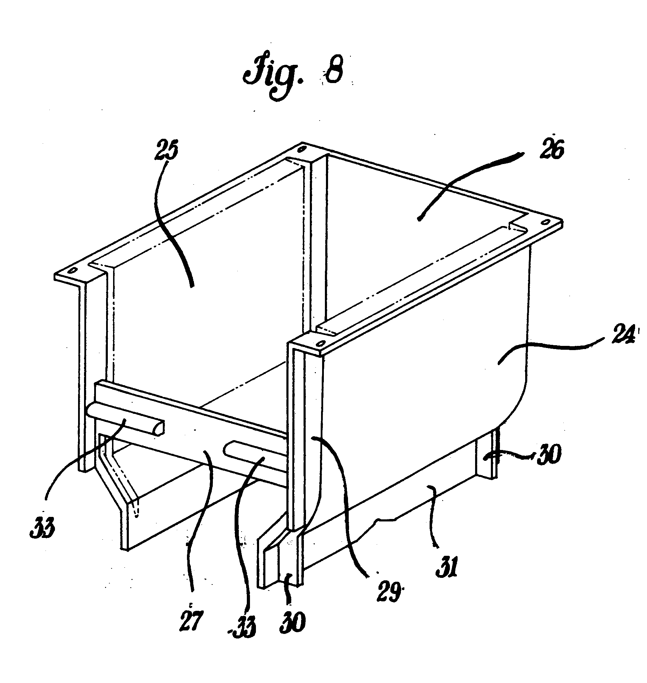

Wie in Figur 3 gezeigt ist, ist der längere Seitenrand jeder Halbschachtel in zwei Hälften unterteilt; in der ersten Hälfte ist der Rand auf eine Seite versetzt, und in der zweiten Hälfte ist er im gleichen Maße auf die andere Seite der Mittellinie Z-Z versetzt. Praktisch weist dieser Seitenrand auf einer Hälfte einen Vorsprung auf und auf der anderen Randhälfte einen Absatz 11, welche die gleiche Höhe bezüglich der Linie Z-Z haben. Außerdem, wie man aus den Figuren 4 und 5 entnehmen kann, ist eine Versetzung auch in Querrichtung vorgesehen, so daß nach Verknüpfung der beiden Halbschachteln der obere Teil zur Hälfte in den unteren Teil eintritt und zur anderen Hälfte der untere Teil in den oberen Teil.

Mit Bezug auf Figur 5 kann man sehen, daß jeder Schachtelteil einen nach außen biegsamen Haken aufweist, dessen End einen Vorsprung 13 hat. Auf der anderen Seite weist jeder Schachtelteil einen Sitz 14 auf mit einem Zahn 15. Die Verschlußteile 12, 13 einerseits und 14 und 15 andererseits ergänzen sich baulich untereinander, so daß, wenn die beiden Halbschachteln zusammengekuppelt werden (Figuren 3 und 4), man nicht nur eine einwandfreie Zusammenkupplung derselben und ein präzises Aneinanderpassen der längeren und kürzeren Ränder erhält, sondern auch ein gegenseitiges Ineinandergreifen und Blockieren der Hakenanordnung 12, 13 einer Halbschachtel mit der Hakenanordnung 14, 15 der anderen Halbschachtel.

Auf dem Boden jedes Schachtelteiles sind zwei Profilstücke 16, 17 und 18, 19 vorgesehen, die sich längsweise und parallel zueinander erstrecken und eine Parallelepipedform haben und nach innen vorspringen. Diese Profilstücke sind zum Blockieren der Kassetten vorgesehen, wie es im Folgenden beschrieben wird.

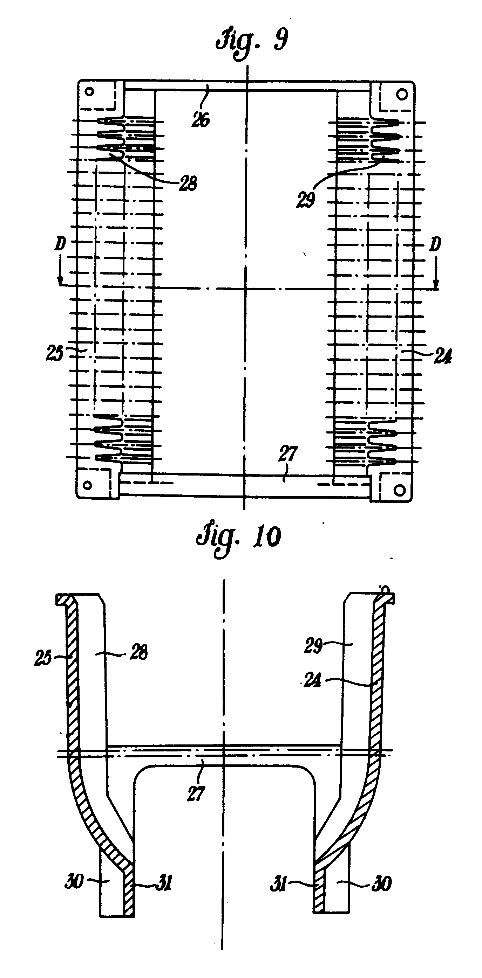

Der Deckelteil der Schachtel bzw. die obere Halbschachtel unterscheidet sich vom Bodenteil der Schachtel nur durch das Vorhandensein von zwei Rippenanordnungen 20, 21, welche längs der beiden Profilelemente 16 und 17 in der Preßform separat montiert sind. Solche Anordnungen bestehen aus einer Mehrzahl von kammartigen Rippen, welche elastisch verformbar sind und deren untere Enden 22 und 23 rechtwinklig nach innen ausgebogen sind, wie man besser in Figuren 4, 5, 6 und 7 sehen kann. Die untere Fläche jedes waagerechten Endsegments 22, 23 weist eine kleine Kerbe auf, in welche der Rand einer Siliciumscheibe eingreift.

Mit Bezug auf Figuren 8 bis 10 wird nun die die Siliciumscheiben aufnehmende Kassette in Einzelheiten beschrieben. Allgemein betrachtet weist diese Kassette den gleichen Aufbau der aus dem Stand der Technik bekannten Kassetten auf und besteht aus zwei Längswandungen 24, 25, die durch zwei Querwände 26, 27 verbunden sind und einen Satz von Rippen aufweisen, welche einen Satz von Aushöhlungen (im allgemeinen 25) zur Aufnahme der Siliciumscheiben bilden. Es ist zu bemerken, daß der untere Teil der beiden Längsgestelle 24 und 25 eine gleichmäßige Kreisform entsprechend dem Radius der Siliciumscheiben hat.

Als wesentliche Unterschiedsmerkmale der erfindungsgemäßen Kassetten sind die Querrippen 30 anzusehen, welche auf dem Boden der Kassette angeordnet sind und an den Fußleisten 31 in der Nähe von vier Kanten befestigt sind. Wie man insbesondere aus Figur 2 entnehmen kann, kommen die Rippen 30 und die Profilelemente des unteren Schachtelteiles miteinander in Eingriff, um die Kassette zu zentrieren und jegliche Verstellung in Quer- und Längsrichtung zu vermeiden.

Eine bevorzugte Durchführungsform der Kassette besteht darin, eine der beiden Querwände (in Figur 8 Wand 27) in Form eines Stegs auszuführen, der durch eine Profilleiste 33 verstärkt ist. Diese Profilleiste ist vorzugsweise in der Mitte unterbrochen. Der Steg 27 ist direkt mit den Seitenwänden 24 und 25 verbunden; er kann sowohl in Höhe des Mittelpunktes der in der Kassette einzusteckenden Siliciumscheiben als auch tieferliegend angeordnet sein.

Wie man in Figur 4 sehen kann, ist die Kassette in der Schachtel nicht nur durch das Zusammenwirken der Füße 31 und der Rippen 30 der Kassette mit den Profilelementen 18 und 19 festgehalten, sondern auch durch das Zusammenwirken der oberen Halbschachtel und der Rippenanordnungen 20 und 21, welche mit den oberen bzw. seitlichen Rändern der Siliciumscheiben, die in den Querrippen 28 und 29 der Kassette angeordnet sind, in Eingriff kommen.

Die verformbaren Rippen 20, 21 dienen zum Blockieren der Siliciumscheiben. Der Abstand zwischen jeweils zwei Rippen entspricht genau dem Abstand von jeweils zwei Querrippen 28 und 29. Die Rippen 20 und 21 sind in dem Deckel so angeordnet, daß sie genau über den Ausbuchtungen zwischen den Querrippen zu liegen kommen. Wie man in Figur 4 sehen kann, blockieren die einzelnen verformbaren Rippen und insbesondere deren waagerechte Segmente 22, 23 die Siliciumscheiben durch eine gleichmäßig verteilte Druckwirkung im Gegensatz zu den bekannten Rippen, welche einen lokalisierten und folglich größeren Druck ausüben und somit für die Siliciumscheiben gefährlicher sind. Es soll außerdem bemerkt werden, daß die Blockierwirkung ohne Gleiten zwischen den Scheibenrändern und den Rippen erfolgt, da die Rippen gegen den Kassettenrand blockiert sind und sich nur an deren waagerechten, den Rand jeder Siliciumscheibe umgreifenden Segment verformen.

Die ausgerundete Gestaltung der die Scheiben aufnehmenden Aushöhlungen gestattet eine gleichmäßig verteilte Berührung mit den Rändern der Scheiben, wodurch punktmäßige Drucke und Drehverstellungen der Scheiben vermieden werden, und es wird außerdem erreicht, daß die Scheiben längs deren Achse fluchten und zwar dadurch, daß der umhüllende Sitz mögliche Verstellungen aus der linearen Anordnung der Scheiben reichlich neutralisiert, wobei diese Verstellungen durch eine eventuelle Abstützung der Scheiben an deren primären Abflachungen hervorgerufen werden können.

Ein weiteres, bekanntes Baumerkmal der erfindungsgemäßen Schachtel besteht darin, daß am Bodenteil und am Deckelteil Außenfüße vorgesehen sind; es sind zwei Füße 32 für jede Kante dargestellt, welche in geometrisch versetzten "feder- und nutartigen" Stellungen rechtwinklig angeordnet sind, um dadurch das Aufstapeln mehrerer Schachteln ohne Gefahr eines ungewollten Heruntergleitens zu ermöglichen.

In den genannten Figuren wurde eine bevorzugte Ausführungsform der vorliegenden Erfindung beschrieben. Es ist jedoch selbstverständlich, daß verschiedene Abänderungen und Varianten der baulichen Einzelheiten seitens der Fachleute angewandt werden können, ohne dadurch aus dem Erfindungsrahmen herauszugehen.

## Patentansprüche

1. Behälter zur Aufbewahrung und Beförderung von Siliciumscheiben, bestehend aus drei Teilen, und zwar einer unteren Halbschachtel, einer oberen Halbschachtel oder Deckel, welche miteinander zur Bildung der äußeren Schutzschachtel formschlüssig lösbar verbunden werden und in dieser Schachtel angeordneten Kassetten, die eine Mehrzahl von Sitzen zur Aufnahme und Aufbewahrung einer Mehrzahl von Siliciumscheiben aufweisen, des weiteren Mittel (12, 13, 14, 15), welche zwischen der unteren und oberen Halbschachtel verteilt sind, sich untereinander ergänzen und miteinander zusammenwirken, um die beiden Halbschachteln zu schließen und miteinander zu blockieren, sowie Profilelemente (18, 19, 16, 17) im inneren Bodenteil der unteren und oberen Halbschachtel, welche mit den Fußleisten am Boden der Kassette so in Eingriff kommen, daß deren Verstellung in jeder Richtung verhindert wird, gekennzeichnet durch Rippenanordnungen (20, 21), vorgesehen nur an der oberen Halbschachtel, die der Blokkierung der Kassette und zum Festhalten der Siliciumscheiben dienen, welche an ihrem oberen Teil an den zwei Profilelementen (16,17) befestigt sind, wobei die Enden (22, 23) der einzelnen Rippen rechtwinklig zum Inneren der Schachtel hin gebogen sind.

2. Behälter zur Aufbewahrung und Beförderung von Siliciumscheiben nach Anspruch 1, dadurch gekennzeichnet, daß die genannten zwei Halbschachteln miteinander vollkommen identisch sind mit Ausnahme der zusätzlichen Anordnung der genannten Rippenanordnungen (20, 21) zum Blockieren der Kassette und zur Festhaltung der Siliciumscheiben.

3. Behälter nach Anspruch 1, dadurch gekennzeichnet, daß die ausgebogenen Enden (22, 23) der genannten Rippen mit einer unteren Kerbe ausgestattet sind, welche mit den Scheiben in Eingriff kommt.

4. Behälter nach Anspruch 3, dadurch gekennzeichnet, daß die Rippen elastisch verformbar sind.

5. Kassette zur Aufbewahrung und Beförderung von Siliciumscheiben in Behältern nach Anspruch 1, bestehend aus zwei Längswänden, die durch zwei Querwände verbunden sind, welche vorspringende Querrippen zur Bildung von Aushöhlungen für die Aufnahme von Siliciumscheiben aufweisen, dadurch gekennzeichnet, daß am Boden der Kassette Rippen (30) vorgesehen sind, die an Fußleisten (31) in der Nähe der vier Kanten der Kassette befestigt sind und in die Profilelemente (18, 19) des unteren Behälterteiles eingreifen.

6. Kassette nach Anspruch 5, dadurch gekennzeichnet, daß eine der Querwände als Steg (27) ausgebildet ist, auf dem eine Profilleiste (33) angeordnet ist.

7. Kassette nach Anspruch 6, dadurch gekennzeichnet, daß die Profilleiste (33) in der Mitte unterbrochen ist.

8. Kassette zur Aufbewahrung und Beförderung von Siliciumscheiben nach den Ansprüchen 1 und 5, dadurch gekennzeichnet, daß die genannten Sitze zur Aufnahme der Siliciumscheiben in der Kassette einen kreisförmig gekrümmten unteren Teil aufweisen, wodurch eine besser verteilte Berührung zwischen den Sitzen und den Scheiben und eine bessere längliche Fluchtung derselben erreicht werden.

9. Behälter nach den Ansprüchen 1 und 5, dadurch gekennzeichnet, daß der Abstand zwischen den Außenrändern der Fußleisten (31) dem Abstand zwischen den Innenrändern der beiden in der unteren Halbschachtel vorgesehenen Profilelemente (18, 19) entspricht.

10. Behälter nach den Ansprüchen 1 und 5, dadurch gekennzeichnet, daß der Abstand zwischen den Innenrändern der zwei Rippen (30) an der einen Seite der Kassette der Länge der in der unteren Halbschachtel vorgesehenen Profilelemente (18, 19) entspricht.

## Claims

1. Container for the storage and transport of silicon discs, consisting of three pieces, namely a lower box half, an upper box half or lid, which are releasably connected with one another form fittingly to form the external protective box and cassettes arranged in this box which have a plurality of sites for receipt and storage of a plurality of silicon discs, and, in addition, means (12, 13, 14, 15), which are distributed between the upper and lower box halves, are complementary to one another and cooperate with one another in order to lock together and close the two box halves, as well as profile elements (18, 19, 16, 17) in the internal base part of the lower and upper box halves which engage with skirting at the base of the cassette so as to prevent displacement thereof in any direction, characterised by rib arrangements (20, 21), provided only on the upper box half which serve for the locking of the cassette and for the holding steady of the silicon discs and which are secured at their upper part to the two profile elements (16, 17), with the ends (22, 23) of the individual ribs being bent at right angles towards the interior of the box.

2. Container for the storage and transport of silicon discs according to Claim 1, characterised in that the said two box halves are completely identical to one another except for the additional arrangement of the said rib arrangements (20, 21) for locking the cassette and for holding steady the silicon discs.

3. Container according to Claim 1, characterised in that the bent out ends (22, 23) of the said ribs are equipped with a lower notch which engages with the discs.

4. Container according to Claim 3, characterised in that the ribs are elastically deformable.

5. Cassette for the storage and transport of silicon discs in containers according to Claim 1, consisting of two longitudinal walls which are connected by two transverse walls and which have projecting transverse ribs for formation of channels for the receipt of silicon discs, characterised in that there are provided on the base of the cassette ribs (30) which are secured to skirting (31) near the four borders of the cassette and engage the profile elements (18, 19) of the lower container part.

6. Cassette according to Claim 5, characterised in that one of the transverse walls is formed as flange (27) on which a profile fillet (33) is arranged.

7. Cassette according to Claim 6, characterised in that the profile fillet (33) is interrupted in the middle.

8. Cassette for the storage and transport of silicon discs according to Claims 1 to 5, characterised in that the said sites for receipt of the silicon discs in the cassette have a lower part curved in the shape of a circle, as a result of which a better distributed contact between the sites and the discs is achieved and a better alignment thereof is achieved.

9. Container according to Claims 1 and 5, characterised in that the distance between the outer edges of the skirting (31) corresponds to the distance between the internal edges of the two profile elements (18, 19) provided in the lower box half.

10. Container according to Claims 1 and 5, characterised in that the distance between the internal edges of the two ribs (30) at the one side of the cassette corresponds to the length of the profile elements (18, 19) provided in the lower box half.

## Revendications

1. Récipient pour le stockage et le transport de disques de silicium, constitué de trois parties, à savoir une demi-boîte inférieure, une demi-boîte supérieure ou couvercle, qui sont reliées l'une à l'autre de manière amovible, par complémentarité de forme en vue de former la boite de protection extérieure, et des cassettes disposées dans cette boîte, présentant plusieurs logements destinés à recevoir et à stocker plusieurs disques de silicium, le récipient comportant en outre des moyens (12, 13, 14, 15) qui sont répartis entre la demi-boîte inférieure et la demi-boîte supérieure, qui se complètent mutuellement et coopèrent entre-eux pour fermer les deux demi-boîtes et les bloquer l'une avec l'autre, ainsi que des éléments profilés (18, 19, 16, 17) dans la partie de fond intérieure des demi-boîtes inférieure et supérieure, qui viennent en prise avec les baguettes de pied sur le fond de la cassette, de manière à ce que le déplacement de celle-ci est empêché dans toutes les directions, caractérisé par des agencements de nervures (20, 21) prévus uniquement sur la demi-boîte supérieure, qui servent au blocage de la cassette et au maintien des disques de silicium, qui sont fixés à leur partie supérieure aux deux éléments profilés (16, 17), les extrémités (22, 23) des nervures individuelles étant coudées perpendiculairement vers l'intérieur de la boîte.

2. Récipient pour le stockage et le transport de disques de silicium selon la revendication 1, caractérisé en ce que les deux demi-boîtes citées sont totalement identiques l'une à l'autre à l'exception de la disposition supplémentaire des agencements de nervures (20, 21) cités et destinés au blocage de la cassette et au maintien des disques de silicium.

3. Récipient selon la revendication 1, caractérisé en ce que les extrémités coudées (22, 23) des nervures citées sont pourvues d'une entaille inférieure qui vient en prise avec les disques.

4. Récipient selon la revendication 3, caractérisé en ce que les nervures sont déformables élastiquement.

5. Cassette pour le stockage et le transport de disques de silicium dans des récipients selon la revendication 1, composée de deux parois longitudinales qui sont reliées par deux parois transversales, et qui comportent des nervures transversales en saillie pour former des évidements destinées à recevoir des disques de silicium, caractérisée en ce que sur le fond de la cassette sont prévues des nervures (30) qui sont fixées sur des baguettes de pied (31) à proximité des quatre arêtes de la cassette, et qui s'engagent dans les éléments profilés (18, 19) de la partie de récipient inférieure.

6. Cassette selon la revendication 5, caractérisée en ce que l'une des parois transversales est réalisée sous la forme d'une traverse (27) sur laquelle est disposée une baguette profilée (33).

7. Cassette selon la revendication 6, caractérisée en ce que la baguette profilée (33) est interrompue au centre.

8. Cassette pour le stockage et le transport de disques de silicium selon les revendications 1 et 5, caractérisée en ce que les logements cités, destinés à recevoir les disques de silicium dans la cassette, présentent une partie inférieure courbée de manière circulaire permettant d'obtenir un contact mieux réparti entre les logements et les disques et un meilleur alignement longitudinal des ces derniers.

9. Récipient selon les revendications 1 et 5, caractérisé en ce que la distance entre les bords extérieurs des baguettes de pied (31) correspond à la distance entre les bords intérieurs des deux éléments profilés (18, 19) prévus dans la demi-boîte inférieure.

10. Récipient selon les revendications 1 et 5, caractérisé en ce que la distance entre les bords intérieurs des deux nervures (30) sur l'un des côtés de la cassette, correspond à la longueur des éléments profilés (18, 19) prévus dans la demi-boîte inférieure.
